# DEMANDE DE BREVET EUROPEEN

(11) **EP 2 682 982 A2**
(43) Date de publication de la demande: **08.01.2014**
(21) Numéro de dépôt: 13174307.2
(22) Date de dépôt: 28.06.2013
(51) Int. Cl.: H01L 21/673

(54) **Dispositif et procédé de support individuel de composants**

(30) Priorité: 03.07.2012 FR 1256361
(71) Demandeur: COMMISSARIAT A L'ENERGIE ATOMIQUE ET AUX ENERGIES ALTERNATIVES, 75015 Paris (FR)
(72) Inventeur: Sanchez, Loïc, 38500 VOIRON (FR); Bally, Laurent, 38560 JARRIE (FR); Montmayeul, Brigitte, 38190 BERNIN (FR)
(74) Mandataire: Decobert, Jean-Pascal

(57) **Abrégé**

L'invention a trait à un système de support individuel de composants (20), comprenant au moins un composant (20) comprenant chacun une face avant (21) et une face arrière (22) opposée à la face avant (21), et un dispositif de support comprenant un organe de support (40) desdits composants (20), caractérisé par le fait que l'organe de support (40) comporte des alvéoles (2) délimitées chacune par une paroi, au moins une partie des alvéoles (41) recevant chacune un composant (20) par sa face avant (21), les alvéoles (41) comportant une zone d'appui d'une zone de contact du composant (20), la zone d'appui et la zone de contact étant configurées pour que la surface de la face avant (21) du composant (20) ne soit pas en contact avec la paroi de l'alvéole (41).

## Description

### DOMAINE TECHNIQUE DE L'INVENTION

La présente invention concerne un système de support de composants dans lequel chaque composant peut être supporté individuellement.

L'invention porte également sur un procédé de transfert de composants.

Non exclusivement, les composants en question peuvent être des puces électroniques, optiques, mécaniques, ou plus généralement tout composant réalisé par des moyens de la microélectronique encore appelées puces ou vignettes. Par exemple, l'invention peut être appliquée au contexte du collage direct (c'est-à-dire par adhésion moléculaire, sans ajout de matière liante) de puces dans des applications photoniques ou des dispositifs microélectroniques tels que ceux ayant une architecture en trois dimensions, où des composants sont situés en superposition dans diverses couches empilées de sorte à accroître la densité d'intégration.

D'une manière générale, les composants sont des objets à circuits électroniques de taille micrométrique ou millimétrique qu'il convient de rapporter à un substrat, par exemple sur une couche de silicium.

### ETAT DE LA TECHNIQUE

La technique du collage direct est une bonne illustration des difficultés rencontrées lors d'opérations effectuées sur des composants individuels, c'est-à-dire physiquement dissociés et manipulables séparément. Le collage direct est extrêmement sensible au degré de propreté de la surface à coller. Les puces étant typiquement issues d'un support commun dit « wafer » (ou tranche) duquel les composants sont extraits par découpe, de nombreuses particules sont générées et doivent être supprimées par nettoyage des puces, au moins au niveau de la surface du composant qui va venir au contact du substrat receveur lors du collage. La qualité du nettoyage est fondamentale mais le nettoyage doit aussi répondre à des impératifs de productivité. A cet effet, un nettoyage collectif est mis en oeuvre, phase durant laquelle les composants sont à maintenir sur un support unique pour être plus facilement manipulables et transférables collectivement dans des machines de traitement.

On connaît certains moyens pour maintenir collectivement des composants sur un support. Le premier d'entre eux est le support de découpe des composants : une tranche incorporant la pluralité des composants est collée sur un film adhésif tendu sur un arceau métallique pour l'étape de découpe. Une fois découpés, les composants peuvent être nettoyés sur ce support ce qui peut en théorie inclure l'application d'un jet de fluide à haute pression, un brossage de surface des composants et/ou un séchage par centrifugation. Mais la présence d'un film plastique s'avère inadaptée à au moins une partie de certaines de ces phases technologiques. C'est en particulier le cas des nettoyages par la technique du plasma. Et les composants doivent encore ultérieurement être décollés du film plastique par préhension par leur face avant, c'est-à-dire la face qui a été préparée en vue de son collage.

Des supports tels que ceux de la marque Fluorware ® sont réalisés sous forme de cassettes en matières plastiques. Elles ne permettent pas de résister à des traitements de surface agressifs du type plasma, par exemple par bombardement d'O₂ ou UV (pour Ultraviolet)/O₃. Il s'avère que l'efficacité du maintien offert est aussi limitée si bien que la plupart des techniques de nettoyage mécanique (brossage ou mégason par exemple) sont exclues. Des cassettes optimisées connues sous la marque déposée « Gel Pak® » existent, dans lesquelles une tenue temporaire plus forte est possible grâce à un film polymère autocollant. Les composants sont collés sur ce film par leur face arrière et nettoyés par leur face opposée, ici appelée face avant. Mais leur libération de la cassette est ensuite fort complexe : un support grillagé sous-jacent au film autocollant permet l'application d'une aspiration qui déforme et applique le film sur une grille et réduit ainsi la surface de contact entre le film et la face arrière des composants. Cette technologie, très spécifique, n'est pas compatible avec les équipements habituels de la microélectronique et le film autocollant ne résiste pas à des traitements agressifs tels que ceux évoqués plus haut. Aucun traitement thermique n'est possible. Là encore, lors de leur préhension, les composants sont mis en contact avec les têtes de déplacement, par leur face avant. Cela peut nuire à la qualité de la surface des faces avant.

Il existe donc un besoin pour améliorer le support de composants dans lequel les composants sont individuellement maintenus, tout en garantissant une plus grande propreté d'au moins une de leurs faces.

### RESUME

La présente invention permet de remédier en tout ou partie aux inconvénients des techniques actuellement connues.

En particulier, un aspect de l'invention est relatif à un système de support individuel de composants, comprenant au moins un composant comprenant chacun une face avant et une face arrière opposée à la face avant, et un dispositif de support comprenant un organe de support desdits composants, caractérisé par le fait que l'organe de support comporte des alvéoles délimitées chacune par une paroi, au moins une partie des alvéoles recevant chacune un composant par sa face avant, les alvéoles comportant une zone d'appui d'une zone de contact du composant, la zone d'appui et la zone de contact étant configurées pour que la surface de la face avant du composant ne soit pas en contact avec la paroi de l'alvéole. Ainsi, avantageusement la surface de la face avant n'est pas en contact avec la partie de fond de la paroi de l'alvéole.

Alors qu'il existe un préjugé constant consistant à penser que les composants, tels des puces dont la face avant est à coller sur un substrat, doivent reposer par un contact plan de leur face avant sur un plan du support avant leur transfert, l'invention offre une libération de la face avant pourtant toujours placée en regard du support. Ainsi, les composants peuvent être manipulés par leur face arrière qui est accessible tout en évitant que leur face avant ne risque d'être dégradée. On notera par exemple qu'en matière de collage direct de composants sur un substrat, tout défaut de qualité de l'état de surface de la face avant à coller nuit à l'efficacité de la liaison obtenue lors du collage. L'invention, qui préserve la face avant préalablement au collage, améliore sensiblement la qualité du collage.

Selon un aspect de modes de réalisation de l'invention, le composant a une configuration avantageuse dans laquelle la zone de contact est en périphérie de la face avant, comporte une surface de bordure en retrait de la face avant, surface de bordure qui est en outre comme la zone d'appui, une zone fermée. Dans cette option de réalisation, la zone de contact et la zone d'appui coopèrent de sorte qu'une étanchéité relative est permise. Cela permet notamment l'application d'une aspiration pour le maintien du composant. En outre, l'application relative du composant et du dispositif de support est déportée relativement à la face avant si bien que celle-ci est fortement protégée. De plus, le composant est alors bien calé du fait de la coopération d'une zone fermée de la zone de contact, en retrait, et d'une zone fermée de la zone d'appui.

Dans d'autres aspects de modes de réalisation, l'invention est aussi relative à un procédé de transfert de composants comprenant chacun une face avant et une face arrière opposée à la face avant, le procédé comprenant une phase de retournement des composants, caractérisé par le fait que la phase de retournement comporte : une application d'un organe de support autour desdits composants, l'organe de support comportant des alvéoles délimitées chacune par une paroi, au moins une partie des alvéoles recevant chacune un composant par sa face avant, les alvéoles comportant une zone d'appui d'une zone de contact du composant, la zone d'appui et la zone de contact étant configurées pour que la surface de la face avant du composant ne soit pas en contact avec la paroi de l'alvéole, une rotation de l'organe de support de sorte à retourner les composants.

### BREVE DESCRIPTION DES FIGURES

Les figures faisant partie de la présente demande montrent des exemples de réalisation donnés à titre purement indicatif et nullement limitatifs.
- La figure 1 illustre en perspective un dispositif de support utilisable dans une mode particulier de réalisation de l'invention.
- La figure 2 montre une autre partie de ce dispositif, sous forme d'une base vue de dessus.
- La figure 3 présente, en coupe suivant l'épaisseur du dispositif, une coopération possible entre ledit dispositif et des composants, avec application d'une dépression.
- Les figures 4A à 4C montrent des étapes successives de collage direct dans lesquelles les composants sont collectivement transférés depuis le dispositif de support vers un substrat receveur.
- Les figures 5A à 5D illustrent une possibilité d'emploi de l'invention pour le retournement collectif des composants. Ces vues présentent aussi une possibilité avantageuse de l'invention dans laquelle la face avant des composants ne voit pas sa surface être mise en contact avec l'organe de support des composants après retournement.
- La figure 6 propose une alternative de configuration pour l'organe de support.
- Les figures 7A à 7C sont des étapes successives de traitement technologique de composants issus d'un même substrat de fabrication avec utilisation du système de l'invention.

### DESCRIPTION DETAILLEE DE MODES DE REALISATION PARTICULIERS

Avant d'entamer une revue détaillée de modes de réalisation de l'invention, sont énoncées ci-après des caractéristiques optionnelles qui peuvent éventuellement être utilisées en association ou alternativement :
- la zone de contact du au moins un composant est située en périphérie de la face avant dudit composant ;
- la zone de contact forme une zone fermée autour de la face avant et que la zone d'appui forme une zone fermée sur la paroi de l'alvéole.

De cette façon, le composant dispose d'une cadre complet sur son support, cadre délimitant dans l'alvéole un volume fermé entre la face avant du composant et les parois de l'alvéole.
- la zone de contact comporte une surface de bordure en retrait relativement à la face avant ;
- la paroi de l'alvéole et la surface de bordure sont configurées pour libérer un espace entre la face avant et la paroi, notamment de fond, de l'alvéole d'au moins 100 micromètres ;
- les alvéoles comportent une embouchure, un fond et une portion de paroi en palier située à un niveau de profondeur intermédiaire entre le fond et l'embouchure, ladite portion de paroi en palier formant au moins partiellement la zone d'appui ;
- la zone de contact et la zone d'appui forment un appui plan suivant un plan parallèle à un plan de la face avant ;
- la zone de contact est au moins une partie de lisière de la face avant ;
- au moins une partie de la zone d'appui est portée par une portion inclinée de paroi des alvéoles formant un rétrécissement de section en direction du fond de l'alvéole ;
- la zone de contact et la zone d'appui sont configurées pour exposer la face arrière du composant à un niveau de hauteur supérieur à celui de l'embouchure de l'alvéole ;
- l'organe de support comporte un circuit d'aspiration débouchant dans chaque alvéole et configuré pour que le composant ait sa face avant en dépression relativement à sa face arrière ;
- le dispositif de support comporte une plaque de réception dotée d'une pluralité de cavités chacune apte à recevoir un composant par sa face arrière, et, pour chaque cavité, au moins un conduit d'aspiration débouchant dans ladite cavité de sorte à ce qu'un composant placé dans ladite cavité ait sa face arrière en dépression par rapport à sa face avant, la plaque de réception et l'organe de support étant configurés pour qu'au moins une partie des cavités soient situées en regard d'au moins une partie des alvéoles quand une face frontale de l'organe de support est en vis-à-vis d'une face supérieure de la plaque de réception ;
- au moins un conduit d'au moins une cavité débouche dans une paroi de fond de la cavité ;
- la au moins une cavité pour laquelle au moins un conduit débouche dans la paroi de fond de la cavité est configurée pour que la face arrière d'un composant placé dans ladite cavité soit en appui surfacique sur la paroi de fond.
- le dispositif comporte un circuit d'aspiration reliant au moins deux conduits et une embouchure de raccordement fluidique.

On tire ainsi pleinement profit de la mutualisation des moyens de support des composants : une plaque suffit pour un maintien individuel des composants et un circuit d'aspiration unique peut être employé pour tout ou partie des conduits débouchant dans les cavités.
- le dispositif comprend aussi une base sur laquelle est placée la plaque de réception, le circuit d'aspiration étant formé, pour une partie comprenant les conduits, dans la plaque de réception et pour une partie, comprenant l'embouchure de raccordement, dans la base.

La base peut participer à former le circuit d'aspiration de manière efficace avec une fabrication simple. La base est avantageusement un élément d'interface entre la plaque de réception (dont la conception, telle que la forme des cavités, est adaptée au type de composants à recevoir) et un organe extérieur tel un support d'une machine sur laquelle le dispositif doit être monté pour traiter les composants (communément appelés en anglais « chuck »). Il peut s'agir d'une machine de nettoyage par mégasons ou d'une machine de collage des composants sur un substrat receveur. Dans ce cas, la base est adaptée au mode de montage sur la machine d'opération. Une base peut être employée pour plusieurs plaques de réception. On peut aussi prévoir qu'une plaque de réception, adaptée à un type de composants, puisse coopérer avec plusieurs bases différentes chacune adaptée à une coopération avec une machine de traitement.
- la base est une plaque sur une face supérieure de laquelle s'applique une face inférieure de la plaque de réception, les cavités étant ouvertes sur une face supérieure de la plaque de réception opposée à la face inférieure.
- le circuit d'aspiration comporte des canaux en creux sur la face supérieure de la base.
- les composants sont des puces électroniques.
- les faces avant des composants sont situées dans un même plan.

Le procédé de l'invention peut comprendre au moins l'une parmi des étapes facultatives suivantes :
- l'utilisation d'un système tel que décrit précédemment ;
- une formation des composants sur un substrat de sorte que leur face arrière est solidaire du substrat, l'application de l'organe de support sur lesdits composants, et, après le pivot, une libération des composants par enlèvement du substrat jusqu'à la face arrière desdits composants ;
- avant la phase de retournement, une mise en appui, par leur face arrière, des composants sur une plaque de réception, le pivot de l'organe de support étant opéré simultanément à un pivot de la plaque de réception.
- avant l'application de l'organe de support, un nettoyage de la face avant des composants.
- la zone d'appui et la zone de contact ne sont mises en contact qu'après le début de rotation de l'organe de support.
- le procédé comprend éventuellement une phase de retournement des composants, les composants étant reçus dans la plaque de réception avant la phase de retournement, la phase de retournement comportant : une rotation de la plaque de réception vers une position de libération, tout en maintenant une application d'une dépression entre la face arrière des composants et la face avant des composants, de sorte à les maintenir dans les cavités, la position de libération étant configurée pour qu'un arrêt de l'application d'une dépression entraine une chute par gravité des composants ; un placement de la plaque de réception et de l'organe de support dans une position relative telle que la face avant des composants est située en vis à vis d'une alvéole avec les zones de contact faisant face aux zones d'appui, tout en maintenant l'application d'une dépression, de sorte à les maintenir dans les cavités ; et un arrêt de l'application d'une dépression, de sorte à ce que les zones de contact des composants viennent en appui par gravité sur les zones d'appui des alvéoles.

On entend ici par cavité 2 ou alvéole 41, toute disposition structurelle apte à former un volume de rétention d'un composant 20. Il peut s'agir d'un relief formé en creux dans une couche d'un substrat 30 ou d'une association de surfaces pariétales entourant de manière continue ou non le composant 20 mais servant au minimum de butée en position suivant plusieurs directions. La paroi des cavités 2 s'entend de l'ensemble de la surface définissant le volume de la cavité. Typiquement la paroi comprend un fond, amené à être en vis-à-vis de la face avant 21 d'un composant 20, et une partie de paroi latérale ayant une dimension suivant la hauteur de la plaque de réception 1 (correspondant également à la hauteur des composants qui y seront logés, soit perpendiculairement à la face avant).

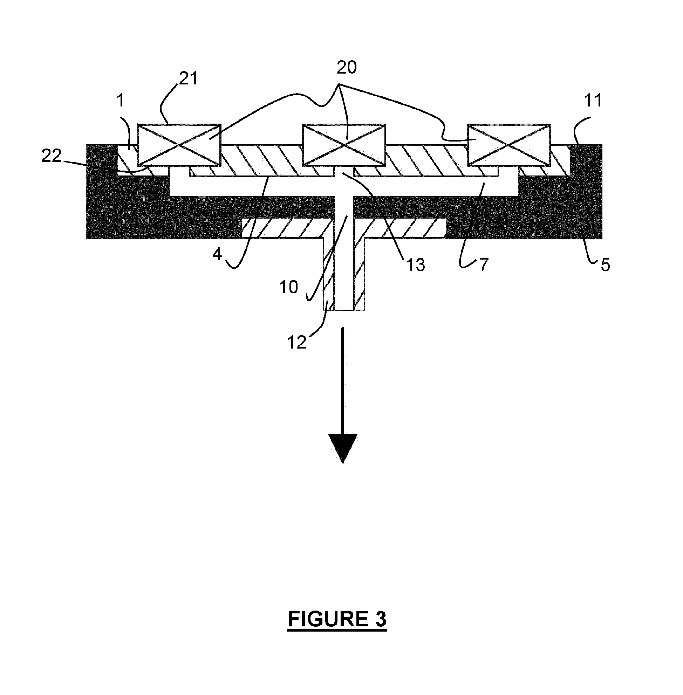

L'invention s'adresse potentiellement à tous types de composants. La figure 3 schématise un exemple de forme de tels composants 20. Ces derniers y comportent une face avant 21 pouvant servir de face active et en particulier de face par laquelle le composant 20 sera rapporté sur un substrat. La face avant 21 est avantageusement plane et les faces avant 21 de tous les composants 20 sont avantageusement situées dans un même plan. Opposée à la face avant 21, une face arrière 22 est formée. Elle peut, comme dans le cas de la figure 3, être parallèle à la face avant 21. Des faces latérales joignent la face avant 21 et la face arrière 22. Globalement, les composants 20 pourront avoir une forme parallélépipédique rectangle.

Typiquement, de tels composants peuvent être obtenus par fabrication sur une même tranche, par exemple de silicium, puis découpés à l'aide d'une scie diamantée.

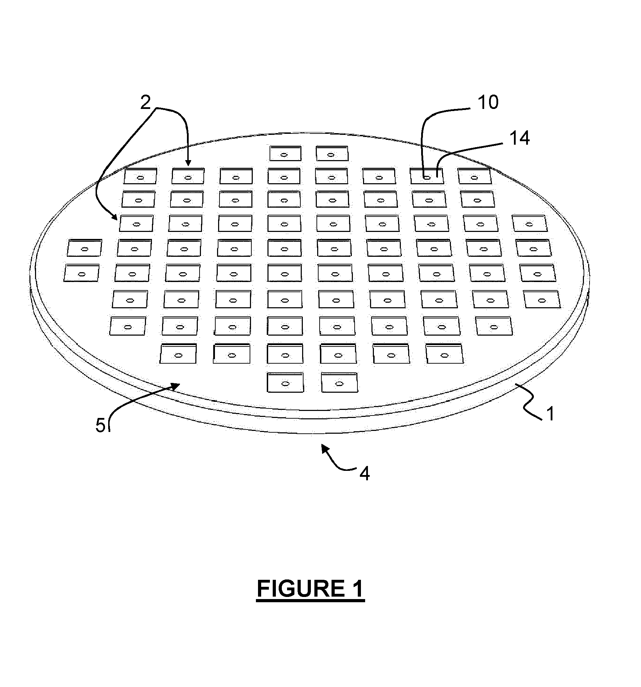

L'invention est ci-après décrite dans le cadre de modes de réalisation dans lesquelles le système comporte, outre l'organe de réception 40 et des composants 20, d'autres constituants. En particulier, dans les cas décrits en commençant par les figures 1 à 4D, le dispositif de support est doté d'une plaque de réception 1. On verra que cette partie du dispositif de support peut coopérer avec l'organe de support 40 de manière avantageuse dans le cadre d'un retournement des composants 20.

Néanmoins, l'invention est aussi parfaitement applicable à des modes de réalisation pour lesquels il n'y a pas de plaque de réception. En particulier, l'organe de support 40 peut se suffire à lui-même dans l'invention.

L'ordre de description donné ci-après, qui débute par une présentation de la plaque de réception 1 et d'une base 5, ne se justifie donc que par un choix de rédaction ne révélant aucunement une quelconque priorité d'importance des caractéristiques qui sont ci-après détaillées.

La partie du dispositif de l'invention illustrée en figure 1 permet de recevoir les composants 20 dissociés. Ils sont insérés chacun dans une cavité 2 d'une plaque de réception 1. Cette dernière est avantageusement en silicium ou en une autre matière dont les propriétés sont compatibles avec les applications technologiques à réaliser, telles des nettoyages agressifs.

La forme et les dimensions de la plaque de réception 1 sont préférentiellement compatibles avec les machines industrielles de microélectronique et notamment manipulables par des robots automatiques. Ces cavités 2 sont de forme et de taille adaptées à la réception des composants. Il s'agit préférentiellement de parties en creux dans la matière de la plaque de réception 1 bien que d'autres configurations soient possibles. La lithographie est un procédé possible pour former les cavités 2.

Les composants 20 sont insérés dans les cavités 2 de sorte à ce que leurs faces arrière 22 pénètrent dans le volume des cavités 2. Les composants 20 étant normalement de même géométrie, les cavités 2 sont avantageusement aussi similaires. Elles autorisent préférentiellement un traitement de la face avant 21 des composants 20 et, à cet effet, la profondeur des cavités 2 (à savoir la hauteur entre leur fond 14 et leur ouverture d'insertion des composants 20) est inférieure à la hauteur entre la face avant 21 et la face arrière).

On comprend que les cavités 2 peuvent produire un maintien mécanique des composants 20. Néanmoins, il n'est pas nécessaire, selon l'invention, que la cavité 2 soit particulièrement ajustée en taille à la dimension du composant 20 à recevoir. Ainsi, la paroi latérale de la cavité 2 n'est pas nécessairement en contact avec le composant 20. Le dispositif de support présente d'autres dispositions pour maintenir les composants 20 sur la plaque de réception 1. Plus précisément, des conduits 13, notamment visibles en figure 3, assurent un passage fluidique de sorte à mettre en dépression la face arrière 22 des composants 20 relativement à la face avant 21.

Chaque conduit 13 débouche dans une cavité 2, de préférence au niveau du fond 14.

Plusieurs conduits 13 peuvent déboucher dans une même cavité 2. La partie débouchante du conduit 13 peut être exécutée sous forme d'un trou traversant l'épaisseur de la plaque de réception 1 depuis le fond 14 de la cavité 2 vers la face inférieure 4 de celle-ci (qui est opposée à une face supérieure 3 par laquelle les composants 20 sont introduits dans les cavités 2). Une alternative consiste à prévoir que les conduits 13 comportent une portion sous forme de canal serpentant dans la plaque de réception 1 et débouchant dans la cavité 2. La fabrication d'un tel canal tout comme celle des trous peut être faite par lithographie. Un diamètre de 1mm pour chaque trou donne satisfaction. Par exemple, un trou de diamètre correspondant à environ 10% de la plus grande dimension du fond 14 est acceptable. Une aspiration de l'ordre de 880mbar permet de réaliser la plupart des opérations technologiques souhaitées.

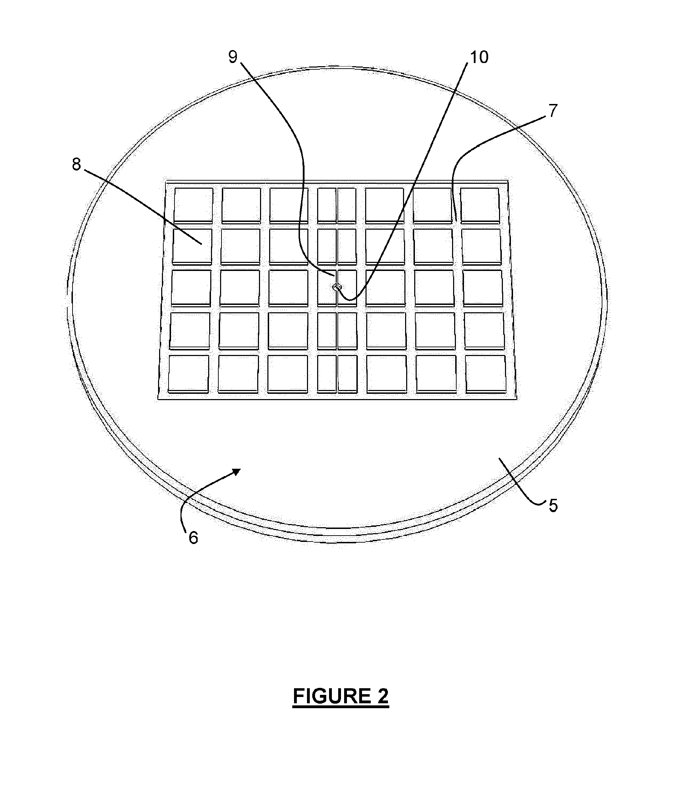

La plaque de réception 1 peut se suffire à elle-même pour recevoir les composants 20 et assurer la mise en dépression de leurs faces arrière 22. On peut néanmoins l'associer à une base 5 dont un exemple apparaît en figure 2. La base 5 s'applique, par une face dite face supérieure 6, sur la face inférieure 4 de la plaque de réception 1. Dans le cas où la base 5 et la plaque de réception 1 sont en silicium, un collage direct peut assurer leur assemblage. Des éléments mécaniques, tel le rebord 11 présenté en figure 3 peuvent aussi être mis en oeuvre.

D'une manière générale, la base 5 sert avantageusement à former une partie du circuit d'aspiration dont les conduits 13 sont les parties terminales et à autoriser l'interface avec un équipement extérieur. Cette interface peut être un montage mécanique du dispositif dans une machine (telle une machine de nettoyage plasma) et/ou être un raccordement fluidique du circuit d'aspiration.

Les figures 2 et 3 présentent plus en détail un mode de réalisation de la base 5 et sa coopération avec la plaque de réception 1. A sa face supérieure 6, la base 5 comporte une portion de circuit d'aspiration avec au moins un canal 7 ici en creux par rapport à la face supérieure 6. Les canaux 7 y forment un motif gaufré, par exemple obtenu par lithographie, avec une communication entre les canaux permettant de les relier et d'assurer un passage de fluide depuis un trou 10, illustrée en figure 2 au centre de la base 5, via un canal 9 de ramification. Typiquement, les canaux 9, 7 sont des rainures parallèles ou perpendiculaires entre elles définissant, entre elles des plots 8. Les canaux 9, 7 sont positionnés en correspondance de la partie du circuit d'aspiration formée dans la plaque de réception 1 de sorte à ce que ces deux parties de circuit communiquent entre elles et que chaque conduit 13 soit en communication fluidique avec la partie du circuit de la base 5. Cette communication ressort particulièrement de la figure 3.

Le trou 10 se prolonge avantageusement au travers de la base 5 en direction de sa face inférieure pour permettre un raccordement à un équipement d'aspiration. La position d'entrée du trou 10 forme alors une embouchure de raccordement 12.

Le dispositif de l'invention peut être mis en oeuvre comme suit :
- constitution d'une plaque de réception 1 dans laquelle les cavités 2 sont adaptées au type de composants 20 à supporter ;
- constitution éventuelle d'une base 5 complémentaire de la plaque de réception 1 et permettant l'interface du dispositif avec au moins un équipement extérieur dont un système d'aspiration, si l'équipement extérieur n'et pas déjà directement compatible ;
- assemblage de la plaque de réception 1 et de la base 5 ;
- insertion des composants 20 chacun dans une cavité 2 ;
- application d'une dépression sur la face arrière des composants 20 par aspiration au travers des conduits 13 ; durant cette phase, on peut opérer des traitements sur les composants et notamment tout opération de nettoyage de leur face avant 21. Ils sont efficacement maintenus dans les cavités 2. L'aspiration peut, dans son niveau de dépression, être ajustée à l'effort souhaité de retenue à l'arrachement des composants 20.

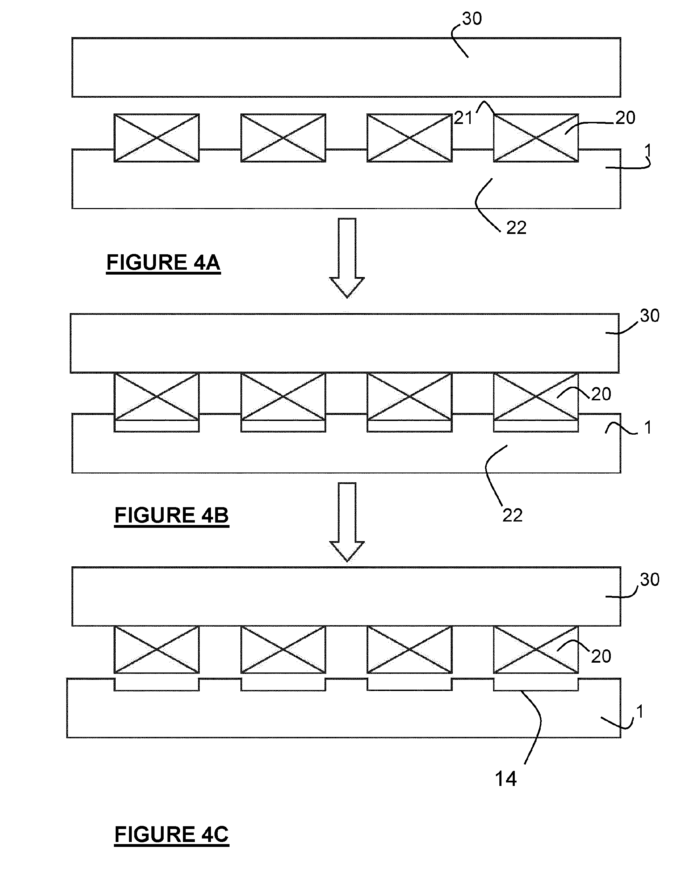

Les figures 4A à 4C montrent un autre exemple d'utilisation du dispositif de l'invention. Après nettoyage de leur face avant 21, les composants 20 vont être transférés depuis la plaque de réception 1 vers un substrat 30, par collage direct. Un rapprochement de la plaque de réception 1 et du substrat 30 est opéré jusqu'au contact des faces avant 21 à la surface du substrat 30, tel qu'en figure 4B. Le collage proprement dit intervient à cette étape en mettant en oeuvre les conditions nécessaires au collage direct et notamment pour bénéficier de l'attraction de Van der Waals entre les atomes de la surface du substrat 30 et ceux des faces avant 21. Une légère pression peut éventuellement être appliquée par le collage.

Un recuit post-collage est réalisé pour renforcer l'énergie d'adhésion. L'eau des gouttes est éliminée à cette étape.

En figure 4C, le collage est terminé et la plaque de réception 1 peut être retirée, la face arrière 22 des composants 20 sortant de leur contact avec le fond 14 des cavités 2.

Grâce à la technique de support de l'invention mise en oeuvre durant le nettoyage des composants, le demandeur a pu constater une nette amélioration de la qualité du collage direct correspondant aux figures 4A à 4C. Durant des tests, des puces ayant une couche de collage en SiO₂ de 200nm (nanomètres) d'épaisseur ont été rapportées sur un substrat 30 ayant une couche superficielle de 200 nm de SiO₂. Une caractérisation acoustique de l'interface de collage a montré que le nombre et la quantité de défauts (surfaces non collées) étaient très sensiblement diminués relativement à un collage unitaire après un nettoyage unitaire des puces (sans le dispositif de support de l'invention. Ainsi, avec un collage collectif, on a obtenu 100% de puces collées avec 80% de puces collées sans défaut. Le taux de défaut sur la totalité des composants est 0,2 défaut/cm². Pour comparaison sur le même nombre de composants par collage unitaire, seulement 96% des puces sont collées et seulement 15% des puces sont collées sans défaut. Le taux de défaut est dix fois supérieur sur la totalité des composants, soit 2 défauts/cm².

On note donc une très grande amélioration de la qualité de collage lorsque les puces sont supportées par le dispositif de l'invention durant leur nettoyage, de par l'efficacité du maintien mécanique et la capacité de mettre en oeuvre toute technique de nettoyage.

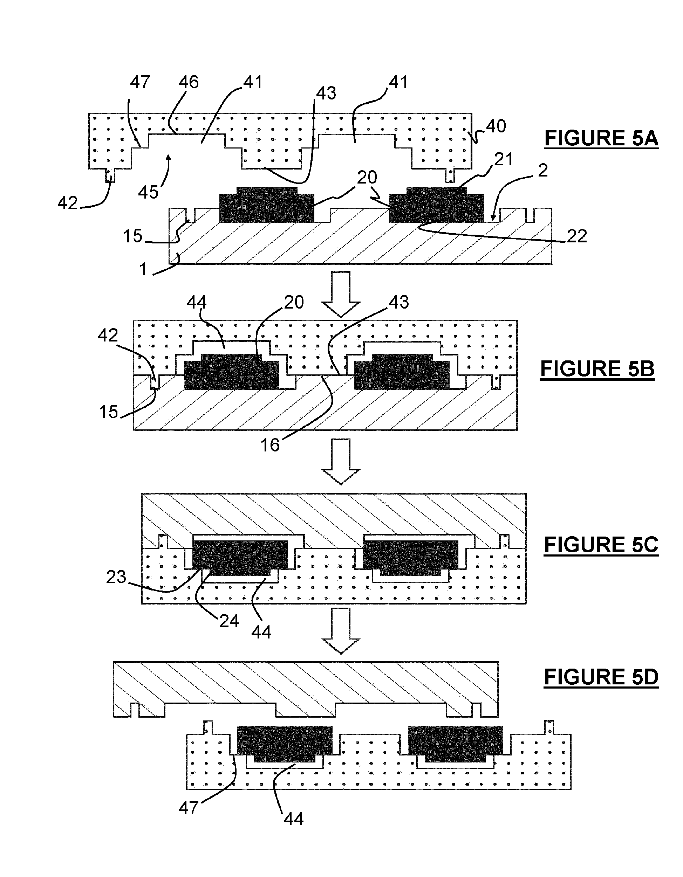

Les figures 5A à 5D illustrent un autre mode de réalisation de l'invention. Le dispositif de l'invention, associé à une pluralité de composants 20 forme un système qui comporte un organe de support 40.

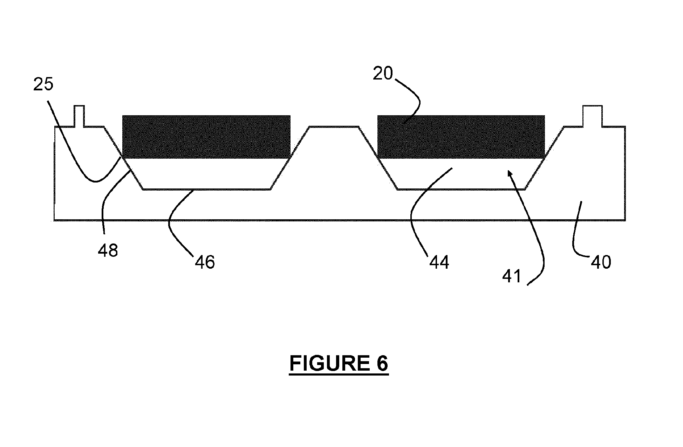

En se référant directement à la figure 5D, la coopération entre l'organe de support 40 et les composants 20 est montrée dans une configuration avantageuse. D'une manière générale, on y note que l'appui des composants 20 sur l'organe de support 40 s'effectue sans impacter la surface de la face avant 21 des composants 20. On entend par là qu'il n'y a pas d'appui surfacique entre la face avant 21 et l'organe de support 40. On verra néanmoins, en référence à la figure 6, qu'un contact linéique est possible, en particulier par la lisière de la face avant 21.

En retournant à la figure 5D, l'organe de support 40 est sous forme d'une plaque, par exemple en silicium, dans laquelle une pluralité d'alvéoles 41 est formée, possiblement par lithographie, gravure ou usinage mécanique. Chaque alvéole 41 a un volume intérieur délimité par une paroi. Cette paroi comprend avantageusement un fond 46 et une portion de paroi entre le fond 46 et l'embouchure 45 de l'alvéole 41 au niveau d'une face frontale 43 de l'organe de support 40, face frontale 43 par laquelle les composants 20 peuvent être insérés dans les alvéoles 41.

La paroi des alvéoles 41 comprend une zone d'appui, continue ou non, surfacique ou linéique ou ponctuelle, au niveau de laquelle une zone d'un composant 20, dite zone de contact continue ou non, surfacique ou linéique ou ponctuelle, peut venir s'appliquer. Cette application s'opère de sorte à ce qu'un espace 44 soit préservé entre la face avant 21 du composant 20 insérée dans l'alvéole 41, et la paroi de l'alvéole 41. Cet espacement préserve l'intégrité de la face avant 21 en évitant les contacts qui pourraient amener des particules sur la face avant 21. Notamment après un nettoyage de la face avant 21, on peut ainsi préserver ses qualités de surface.

Comme dans le cas des cavités 2, les alvéoles 41 sont avantageusement configurées pour que la face arrière 22, ici exposée à l'extérieur de l'alvéole 41 correspondante, soit située au-dessus du niveau de la face frontale 43 de l'organe de support 40.

Dans un mode de réalisation, le système de support de l'invention comprend des composants 20 à la géométrie spécifique pour former la zone de contact apte à coopérer avec la zone d'appui de la paroi des alvéoles 41. Dans le cas des figures 5A à 5D, cette géométrie est telle qu'une bordure 23, située latéralement relativement à la face avant 21, crée une zone de contact à une niveau de hauteur intermédiaire entre la face avant 21 et la face arrière 22. Avantageusement, la bordure est continue tout autour de la face avant 21. Si la zone d'appui de la paroi de l'alvéole 41 est elle aussi continue, cette disposition permet une fermeture complète de l'espace 44, assurant une protection accrue de la face avant 21. A titre préféré, la bordure 23 est uniforme autour de la face avant 21, avec une même largeur et une même hauteur correspondant à la marche repérée 24 en figure 5C. Par exemple, une hauteur de marche 24 de l'ordre de 10 µm (micromètres) est possible.

Bien que cela ne soit pas limitatif, la marche 24 est avantageusement une surface plane dirigée suivant l'épaisseur du composant (c'est-à-dire la dimension entre face avant et face arrière). Cette épaisseur forme la hauteur de marche. Toujours à titre préféré, la bordure 23 est une surface plane s'étendant depuis le pied de la marche 24 vers la périphérie du composant. Cette surface est avantageusement dirigée suivant un plan perpendiculaire à l'épaisseur du composant.

De manière avantageuse, la bordure 23 est configurée pour qu'un écartement minimal, préférentiellement supérieur à 100 µm soit préservé entre la face avant 21 et la paroi, en particulier de fond de l'alvéole 41. Cet écartement, bien supérieur à la taille habituelle des particules susceptibles de se déposer sur la face avant 21, évite que de telles particules, éventuellement présentes sur la paroi de l'alvéole 41, ne soient amenées à contaminer la face avant 21.

Pour accommoder les tolérances de fabrication et espacer la face avant 21 de l'alvéole 41, la largeur de l'alvéole 41 peut être choisie au moins 200µm plus grande que la largeur de la face avant 21. Les bordures 23 sont conçues en conséquence. Sur ce point, on notera qu'un procédé de fabrication de la zone de contact d'un composant peut comprendre les étapes suivantes :
- à partir d'une tranche dite « wafer », création d'une pluralité de composants ;
- avec un outil de découpe d'une première largeur (tel qu'une scie diamantée), formation de lamages entre les composants de la tranche ;
- avec un deuxième outil de découpe, d'une deuxième largeur inférieur à la première largeur, découpe des composants à un niveau médian des lamages de sorte à dissocier les composants tout en formant les bordures 23 par la surface résiduelle des lamages.

La bordure 23 peut aussi être obtenue par d'autres moyens dont une lithographie.

Dans un autre mode de réalisation, qui peut être combiné ou non avec le mode précédent où les composants comportent une bordure 23, les alvéoles 41 comportent une portion de paroi en palier 47. C'est alors sur cette portion qu'est réalisé tout ou partie de la zone d'appui.

La figure 6 montre un autre mode de réalisation du système de support de l'invention dans lequel la paroi des alvéoles comporte des portions inclinées 48 assurant un rétrécissement de l'alvéole 41 en direction de son fond 46. Une inclinaison avec un angle compris entre 30° et 60°, et par exemple 45°, relativement à la face avant 21 du composant 20 est possible. Dans le cas d'un composant 20 de forme parallélépipédique rectangle, il est avantageux que les portions inclinées 48 d'une alvéole forment une partie de tronc de pentaèdre tel une pyramide, la zone d'appui étant ainsi continue, sur une zone de contact du composant 20 qui est réalisée par la lisière 25 complète dudit composant. Cette lisière 25 peut être la ligne fermée bordant la face avant 21. On peut aussi associer cette forme d'alvéole 41 à la forme de composant, à bordure 23, donnée aux figures 5A à 5D, auquel cas la lisière 25 de contact linéique est la ligne du bord extérieur de la bordure 23.

Quelque soit le mode de réalisation de l'organe de support 40, le système est tel que le contact entre les alvéoles 41 et la face avant 21 des composants 20 est au maximum un contact linéique.

Les figures 5A et 5D illustrent un exemple d'utilisation avantageux pour l'organe de support 40, dans lequel ce dernier est employé pour retourner les composants 20 de sorte à passer d'une position dans laquelle c'est la face avant 21 des composants 20 qui est exposée à l'extérieur, à une position dans laquelle c'est leur face arrière 22 qui est exposée. La configuration résultant peut en particulier servir à opérer une préhension des composants 20, par leur face arrière 22, sans toucher la face avant 21 alors que les techniques connues sous le vocable « Pick and Place » impliquent des étapes de préhension par les deux faces.

A la figure 5A, les composants 20 sont supportés par la plaque de réception 1 avantageusement du type précédemment décrit. Cette dernière présente donc préférentiellement pour chaque cavité 2 un conduit d'aspiration bien que les figures 5A à 5D ne l'illustrent pas.

Ainsi placées, les composants 20 ont leur face avant 21 exposée à l'extérieur des cavités 2 et leur face arrière dans les cavités 2. Des opérations technologiques dont une phase de nettoyage peuvent avoir lieu dans cette configuration. L'organe de support 40 et la plaque de réception 1 sont alors rapprochés jusqu'à accostage tel que montré en figure 5B. Dans cette représentation, une partie de la face frontale 43 de l'organe de support 40 vient en appui sur une surface de butée 16 de la plaque de réception 1. A titre optionnel, l'assemblage est sécurisé par une coopération mécanique du type connecteur 42 mâle, connecteur 15 femelle formés chacun sur l'un parmi l'organe de support 40 et la plaque de réception 1.

Dans cette situation, la zone d'appui des alvéoles 41 et la zone de contact des composants 20 peuvent ne pas encore s'appliquer l'une sur l'autre. C'est le cas dans la figure 5B mais ce n'est pas limitatif.

Pour passer à la configuration de la figure 5C, une rotation est opérée. Le mouvement peut être plus complexe qu'une rotation autour d'un seul axe mais la résultante reste de parvenir à une position inversée de l'organe de support 40 et de la plaque de réception 1. En particulier, l'organe de support 40 est alors préférentiellement positionné de sorte à ce que les zones de contact des composants 20 s'appliquent par gravité sur les zones d'appui des alvéoles 41.

Lors du retournement, des dispositions sont avantageusement prises pour éviter un déplacement intempestif des composants 20. A cet effet, une aspiration peut être appliquée dans les conduits 13. En complément ou en alternative, l'ajustement de la zone de contact et de la zone d'appui dans la situation de la figure 5B peut être tel que les mouvements des composants soient bloqués ou limités dans la phase de retournement.

Dans une variante non illustrée, l'organe de support 40 ne participe pas à la phase de retournement. Dans ce cas, la plaque de réception 1 retient les composants par l'aspiration, opère la rotation nécessaire et positionne les composants retournées en regard des alvéoles 41 de l'organe de support 40, de sorte à appliquer les zones de contact des composants 20 sur la zone d'appui des alvéoles 41 ou de sorte que le relâchement de l'aspiration provoque cette application par simple gravité.

Quelque soit le mode de retournement, à l'étape de la figure 5D, la plaque de réception 1 peut être enlevée. Restent les composants 20 en appui sur l'organe de support 40, sans contamination de la face avant 21 des composants 20. Ces derniers peuvent par exemple être alors manipulés individuellement par leur face arrière 22 pour un collage avec un positionnement de haute précision.

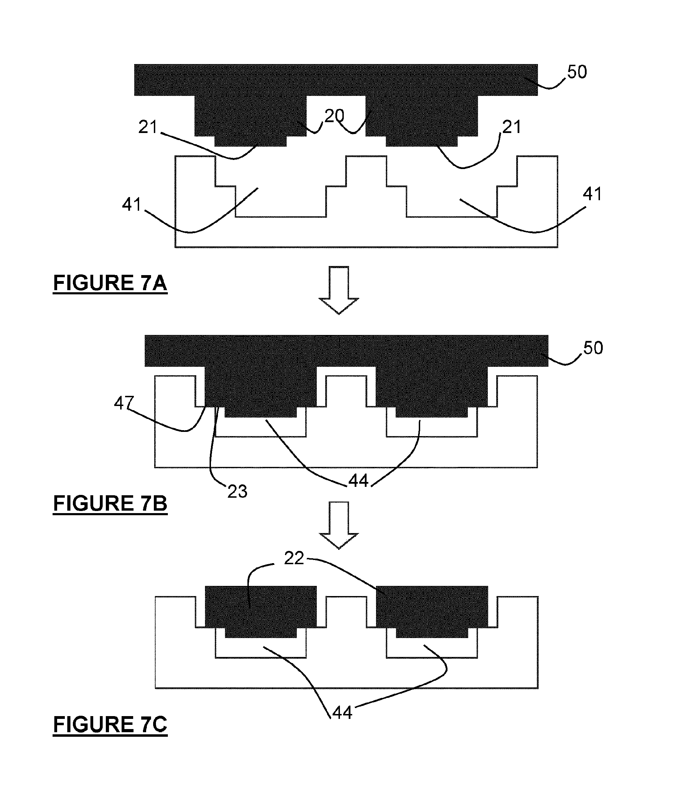

Les figures 7A à 7B proposent un autre mode de réalisation de l'invention dans lequel le retournement des composants 20 est opéré de manière différente aux cas précédents.

Les composants 20 sont réalisés sur un substrat 50, par exemple à partir d'une couche de silicium. Leurs faces avant 21 sont déjà formées et avantageusement nettoyées. On peut ainsi mettre en oeuvre les technologies connues de nettoyage de surface de substrats entiers. A l'issue, les composants 20 sont mis en regard de l'organe de support 40 puis introduits dans les alvéoles 41 par leurs faces avant 21. Cette introduction s'arrête lorsque les zones de contact des composants 20 s'appliquent sur les zones d'appui des alvéoles 41. C'est la configuration de la figure 7B.

Dans cette situation, zones d'appui et zones de contact sont en application relative, ce qui immobilise le substrat 50. Avantageusement, les seules surfaces en contact sont lesdites zones d'appui et de contact. Toujours avantageusement, les composants 20 formés sur le substrat 50 sont en saillie sur une face du substrat et le support et les composants sont configurés pour que ladite face du substrat soit surélevée relativement à l'organe de support 40.

Il s'agit alors de libérer les composants 20 du substrat 50. Un procédé pour ce faire consiste à amincir le substrat, par exemple par rectification ou meulage (grinding en anglais), depuis la face du substrat 50 opposée à celle où se situent les composants 20. L'amincissement se poursuit jusqu'à atteindre la face du substrat 50 où sont les composants si bien qu'ils sont libérés tout en constituant leurs faces arrière 22.

Dans une variante non illustrée, l'organe de support 40 comporte, pour chaque alvéole 41 un ensemble d'aspiration, qui peut par exemple, être similaire à celui décrit pour les cavités 2 de la plaque de réception 1. En particulier, un circuit additionnel d'aspiration peut alors permettre de créer une mise en dépression de la face avant 21 relativement à la face arrière 22, si bien que les composants 20 sont efficacement maintenus dans les alvéoles 41.

Les faces opposées des composants 20 ont été précédemment dénommées face avant 21 et face arrière 22 par simple convention. La face avant 21 des exemples donnés joue un rôle actif dans un collage direct sur un substrat receveur. Néanmoins, l'invention n'est pas limitée à cet exemple et les rôles des faces avant 21 et arrière 22 pourraient être différents.

## Revendications

1. Système de support individuel de composants (20), comprenant au moins un composant (20) comprenant chacun une face avant (21) et une face arrière (22) opposée à la face avant (21), et un dispositif de support comprenant un organe de support (40) desdits composants (20), l'organe de support (40) comportant des alvéoles (41) délimitées chacune par une paroi, au moins une partie des alvéoles (41) étant apte à recevoir chacune un composant (20) par sa face avant (21), les alvéoles (41) comportant une zone d'appui d'une zone de contact du composant (20), la zone d'appui et la zone de contact étant configurées pour que la surface de la face avant (21) du composant (20) ne soit pas en contact avec la paroi de l'alvéole (41), **caractérisé par le fait que** la zone de contact du au moins un composant (20) est située en périphérie de la face avant (21), dudit composant (20) en formant une zone fermée autour de la face avant (21), et que la zone d'appui forme une zone fermée sur la paroi de l'alvéole (41), la zone de contact comportant une surface de bordure (23) en retrait relativement à la face avant (21).

2. Système selon la revendication précédente dans lequel la surface de bordure (23) est en retrait relativement à la face avant (21) suivant une marche (24) d'une hauteur constante..

3. Système selon l'une des revendications précédentes dans lequel la paroi de l'alvéole (41) et la surface de bordure (23) sont configurées pour libérer un espace (44) entre la face avant (21) et une partie de fond (46) de la paroi de l'alvéole (41) d'au moins 100 micromètres.

4. Système selon l'une des revendications précédentes dans lequel les alvéoles (41) comportent une embouchure (45), un fond (46) et une portion de paroi en palier (47) située à un niveau de profondeur intermédiaire entre le fond (46) et l'embouchure (45), ladite portion de paroi en palier (47) formant au moins partiellement la zone d'appui.

5. Système selon l'une des revendications précédentes dans lequel la zone de contact et la zone d'appui forment un appui plan suivant un plan parallèle à un plan de la face avant (21).

6. Système selon l'une des revendications précédentes dans lequel au moins une partie de la zone d'appui est portée par une portion inclinée de paroi (48) des alvéoles (41) formant un rétrécissement de section en direction du fond (46) de l'alvéole (41).

7. Système selon l'une des revendications précédentes dans lequel la zone de contact et la zone d'appui sont configurées pour exposer la face arrière (22) du composant (20) à un niveau de hauteur supérieur à celui de l'embouchure (45) de l'alvéole (41).

8. Système selon l'une des revendications précédentes dans lequel l'organe de support (40) comporte un circuit d'aspiration débouchant dans chaque alvéole (41) et configuré pour que le composant (20) ait sa face avant (21) en dépression relativement à sa face arrière (22).

9. Système selon l'une des revendications précédentes dans lequel le dispositif de support comporte une plaque de réception (1) dotée d'une pluralité de cavités (2) chacune apte à recevoir un composant (20) par sa face arrière (22), et, pour chaque cavité (2), au moins un conduit (13) d'aspiration débouchant dans ladite cavité de sorte à ce qu'un composant (20) placé dans ladite cavité (2) ait sa face arrière (22) en dépression par rapport à sa face avant (21), la plaque de réception (1) et l'organe de support (40) étant configurés pour que au moins une partie des cavités (2) soient situées en regard d'au moins une partie des alvéoles (41) quand une face frontale (43) de l'organe de support (40) est en vis-à-vis d'une face supérieure (22) de la plaque de réception (1).

10. Procédé de transfert de composants (20) comprenant chacun une face avant (21) et une face arrière (22) opposée à la face avant (21), le procédé comprenant une phase de retournement des composants (20), **caractérisé par le fait que** la phase de retournement comporte:
- une application d'un organe de support (40) autour desdits composants (20), l'organe de support (40) comportant des alvéoles (41) délimitées chacune par une paroi, au moins une partie des alvéoles recevant chacune un composant (20) par sa face avant (21), les alvéoles (41) comportant une zone d'appui d'une zone de contact du composant (20), la zone d'appui et la zone de contact étant configurées pour que la surface de la face avant (21) du composant (20) ne soit pas en contact avec la paroi de l'alvéole (41), la zone de contact du au moins un composant (20) étant située en périphérie de la face avant (21) dudit composant (20) en formant une zone fermée autour de la face avant (21), la zone d'appui formant une zone fermée sur la paroi de l'alvéole (41), la zone de contact comportant une surface de bordure (23) en retrait relativement à la face avant (21).
- une rotation de l'organe de support (40) de sorte à retourner les composants (20).

11. Procédé selon la revendication précédente comprenant l'utilisation d'un système selon l'une des revendications 2 à 9.

12. Procédé selon l'une des deux revendications précédentes comprenant une formation des composants (20) sur un substrat (50) de sorte que leur face arrière (22) est solidaire du substrat (50), l'application de l'organe de support (40) sur lesdits composants (20), et, après le pivot, une libération des composants (20) par enlèvement du substrat (50) jusqu'à la face arrière (22) desdits composants (20).

13. Procédé selon l'une des revendications 10 ou 12 comprenant, avant la phase de retournement, une mise en appui, par leur face arrière (22), des composant (20) sur une plaque de réception (1), le pivot de l'organe de support (40) étant opéré simultanément à un pivot de la plaque de réception (1).

14. Procédé selon l'une des revendications 10 à 13 comprenant, avant l'application de l'organe de support (40), un nettoyage de la face avant (21) des composants (20).

15. Procédé selon l'une des revendications 10 à 14 dans lequel la zone d'appui et la zone de contact ne sont mises en contact qu'après le début de la rotation de l'organe de support (40).
